# EUROPEAN PATENT APPLICATION

(11) **EP 4 675 588 A1**
(43) Date of publication of application: **07.01.2026**
(21) Application number: 25187220.6
(22) Date of filing: 03.07.2025
(51) Int. Cl.: G08B 29/02

(54) **MONITORING AN ENCLOSURE FOR HOUSING UTILITY INFRASTRUCTURE**

(30) Priority: 03.07.2024 GB 202409588
(71) Applicant: Vodafone Group Services Limited, Newbury RG14 2FN (GB)
(72) Inventor: LAW, Alan, London, W2 6BY (GB); TURK, John, London, W2 6BY (GB)
(74) Representative: Boult Wade Tennant LLP

(57) **Abstract**

A method for monitoring an enclosure for housing utility infrastructure, the enclosure having an enclosure controller in communication with a maintenance management server. The method comprises receiving at the enclosure controller a measured value of one or more parameter characterising an environment inside the enclosure, each value measured by a respective one or more sensors located at the enclosure. The enclosure controller further receives one or more image depicting at least a region of the interior of the enclosure, each image acquired at a respective one or more image acquisition devices located at the enclosure. The enclosure controller sends to the maintenance management server the measured value of the one or more parameter and the one or more image. The method further determines if an anomaly is detected inside the enclosure by comparing at the maintenance management server the measured value of each one or more parameter to at least one stored value of the corresponding parameter and/or comparing each one or more image to at least one stored corresponding image, the at least one stored value of a corresponding parameter and the at least one stored corresponding image associated with the enclosure. If an anomaly is detected, then an alert is issued by the maintenance management server.

## Description

### Field of the invention

A system and method for monitoring an enclosure for housing utility infrastructure. For instance, the enclosure may be for housing a base station in a communications system.

### Background to the disclosure

Part of the infrastructure of various utilities include cabinets or enclosures on streets or in public areas which house utility equipment. For instance, telecommunications companies may house a bank of cable connections or switches for optical fibre broadband networks in a lockable cabinet on the street. In another example, mobile base stations may be housed in similar cabinets. Such enclosures can be prone to vandalism, damage due to poor weather, or even infiltration by animals, as well as general wear and tear or equipment faults. All of these issues can affect the function of the equipment housed within the enclosure and may result in a deterioration in the service provided by the utility.

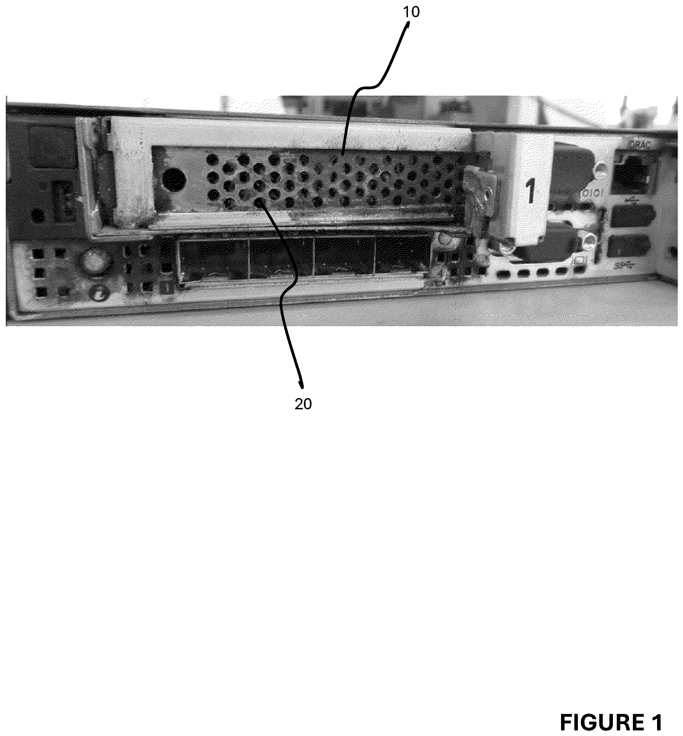

Although the cabinets or enclosures tend to be closed, even under normal use, dirt and dust can enter an enclosure and build-up on the equipment housed therein. This can cause a fault at the equipment. FIGURE 1 shows an example of dirt 10 built up at an example equipment that has been removed from an existing cabinet. The dirt has built up especially around the air inlet 20 of the equipment.

Presently, faults or deterioration in equipment housed in the described enclosures are detected by periodic in-person checks during site visits, or in-person visits once failure of the equipment occurs. Occasionally, a basic alarm is deployed at the enclosure to detect a failure in an aspect of the cabinet (for instance, if the cabinet is unlocked). Such an approach is often inefficient and can typically result in a period of downtime of equipment after a fault has occurred. This can cause disruption to the utility service provided by the equipment in the enclosure.

As such there is a desire for an improved system and method for monitoring an enclosure for housing utilities infrastructure.

### Summary of the disclosure

In a first aspect, there is a method for monitoring an enclosure for housing utility infrastructure, the enclosure having an enclosure controller in communication with a maintenance management server, the method comprising:
receiving at the enclosure controller a measured value of one or more parameter characterising an environment inside the enclosure, each value measured by a respective one or more sensors located at the enclosure;
receiving at the enclosure controller one or more image depicting at least a region of the interior of the enclosure, each image acquired at a respective one or more image acquisition devices located at the enclosure;
sending by the enclosure controller to the maintenance management server the measured value of the one or more parameter and the one or more image;
determining if an anomaly is detected inside the enclosure by comparing at the maintenance management server the measured value of each one or more parameter to at least one stored value of the corresponding parameter and/or comparing each one or more image to at least one stored corresponding image, the at least one stored value of a corresponding parameter and the at least one stored corresponding image associated with the enclosure;
wherein, if an anomaly is detected, then issuing an alert by the maintenance management server.

An anomaly may be a fault or may be an indication of an unexpected change within the enclosure (that may lead to a fault in future, and so require further investigation). Beneficially, the method allows more efficient identification of an anomaly at an enclosure housing a utility. This is because the method looks for changes or differences in visual aspects or in measured parameters at the enclosure, and so can identify a gradual onset or slow deterioration of an error or problem at the enclosure (for example, a change compared to a running average or compared to an ideal value), rather than monitoring for a specific instance when an error or problem is identified (which would be only observed, for instance, when a measured parameter exceeds a threshold). This means issues can be identified earlier and addressed more quickly, reducing periods of poor performance or downtime for equipment housed in an enclosure. The method may allow prioritisation of a maintenance schedule for equipment housed in particular enclosures or may allow utility providers to pre-empt future faults in the equipment housed in an enclosure.

The one or more sensors may be located inside the enclosure and/or the one or more image acquisition devices may be located inside the enclosure. However, in some cases, at least one of the sensors and/or image acquisition devices may be arranged at the enclosure to measure or observe an aspect of the exterior to the enclosure. This may be useful to measure a 'delta' or a difference in a parameter inside the enclosure compared to the same parameter outside (for example, interior temperature relative to the outside air temperature).

Determining if an anomaly is detected inside the enclosure by comparing at the maintenance management server the measured value of each one or more parameter to at least one stored value of a corresponding parameter and/or comparing each one or more image to at least one stored corresponding image, may comprise: comparing the measured value of each one or more parameter and/or each one or more image to at least one stored value of a corresponding parameter or stored image; and determining that an anomaly is detected if there is a difference between at least one of the measured value of the one or more parameter and the stored value of the corresponding parameter or between the one or more image and the stored corresponding image. In other words, an anomaly is detected if there has been a significant change in the interior of the enclosure. In general, the enclosure is a closed environment, and so a change (for instance, movement of a wire at a socket) may indicate an anomaly. In some cases, an anomaly may only be noteworthy if the change is of a significant amount (for instance, a small change in temperature in the interior of the enclosure may be considered normal, whereas a large change in temperature may be considered an indication of a fault).

Determining that an anomaly is detected if there is a difference between at least one of the measured value of the one or more parameter and the stored value of the corresponding parameter may comprise: determining a magnitude of the difference between a one of the measured value of the one or more parameter and a stored value of the corresponding parameter; and determining that an anomaly is detected if the magnitude of the difference exceeds a predefined threshold associated with said parameter. In other words, the change is deemed significant enough to be defined as an anomaly if the difference between the measured and expected (stored values) is greater than a predefined amount (represented by the threshold). The amount may be a finite value or a percentage of the stored value. This can take into account of normal ranges for certain parameters, outside of which a fault is indicated.

Determining that an anomaly is detected if there is a difference between at least one of the one or more image and the stored corresponding image, may comprise: determining any change between a one of the one or more image and the stored corresponding image using automated image comparison techniques; and determining that an anomaly is detected if a change is determined. Using automated image comparison techniques (or automated image recognition techniques) may comprise comparing predefined areas or predefined features of each image. Automated image comparison techniques may compare a signal value (for instance light intensity, or RGB value) at a specific pixel or group of pixels (where that specific group of pixels may be selected to represent a particular indicator, or a specific wire connection or plug socket). Automated image comparison techniques may make use of different light levels at different times of day. In some cases, lighting may be provided inside the enclosure to ensure a stable light level. Automated image comparison techniques may make use of machine learning after training on a suitable training data set. Comparison of images makes use of the closed environment of the enclosure, which typically should remain unchanged between visits from authorised personnel. Therefore, any change in the visual appearance of the interior of the enclosure (for example, movement at a plug or connector, or change of colour of an indicator, or change of colour due to build up of dirt at a vent) might indicate a fault or anomaly.

Beneficially, the described method, and in particular the determination of a difference between at least one of the one or more image and the stored corresponding image to detect an anomaly, can be used to: i) Capture the exact cabling configuration inside an enclosure and flag any unexpected changes post a site visit modification (for instance, failure to apply necessary covers to inlets/cable management); ii) Use images to support the establishment of digital twin models of specific deployed cabinets; iii) Detection of unexpected equipment installation within cabinets (e.g. installation of unauthorised equipment); iv) Detection of unexpected elements (rodents, rain, etc) within the enclosure.

The images may be obtained by use of a camera (or image acquisition equipment) with a wide angle lens and/or flash, whilst other sensors within the enclosure can be deployed to obtain sensor readings. Then, these images and sensor readings are used to identify changes for detecting or determining an anomaly has occurred. The images and sensor readings can further be used to create a digital twin model for reviewing ongoing changes in the cabinet or enclosure environment, and identify unexpected changes or items (rodents), etc. therein. Once identified, these events or changes indicating an anomaly can be shared with a remote or centralised network operations or maintenance team so that the appropriate mitigation actions can be taken. Such mitigation items may include shutdown if a security threat is identified, the triggering of pre-emptive maintenance (such as server and/or cabinet repair), or an instruction to monitor for further changes.

Comparison of an acquired image with a stored image of the interior of a given enclosure (or a portion of the interior) may be used to identify changes in LED indicators at equipment housed in the enclosure, corrosion of wires in the enclosure, disconnected or dislodged wires at equipment within the housing, or incursion and build-up of dirt or dust on the equipment (or possibly specific portions of the equipment) which could indicate failure of a seal to the enclosure. Increased light levels inside the enclosure could indicate that the enclosure has been opened, or that there is unauthorised access.

Determining that an anomaly is detected if there is a difference between at least one of the measured value of the one or more parameter and the stored value of the corresponding parameter or between the one or more image and the stored corresponding image, may comprise: determining that an anomaly is detected if there is a difference between at least two of the measured value of the one or more parameter and the stored value of the corresponding parameter and/or the one or more image and the stored corresponding image. In other words, the method may require that a change is identified in one or more of the parameters or images, or in two or more of the parameters or images, in order to determine that an anomaly is detected. The method may require a change to be observed in any specified number of parameters or images in order to determine that an anomaly is detected. In general, requiring a change in a greater number of parameters or images will reduce the number of false indications of an anomaly by the method. However, requiring a change in a greater number of parameters or images may also reduce the sensitivity of the anomaly detection.

With this in mind, it will be understood that determination of a change in certain parameters or images may be a more reliable indication of an anomaly or a fault than a change in other parameters or images. For instance, determination of a small change in the interior temperature in an enclosure may not, if considered alone, necessarily indicate an anomaly. However, identification that in LED warning indicator is illuminated in an image of equipment inside the enclosure may always indicate an anomaly. Therefore, the presence of a change (or lack of a change) in each parameter or image may be considered to have differing importance. The method may take this into account by applying a weighting to each parameter and/or image and consequently a change indicated in that parameter and/or image. For some enclosures, the weightings for certain parameters or images could even be zero, and as such a change in that parameter or image would be disregarded. In this way, the method can be adapted to provide a reliable detection of anomalies at a specific enclosure.

In an example, a difference between each of the measured values of the one or more parameter and the stored value of the corresponding parameter may be calculated as a proportion or a percentage (or other normalised value). A difference between the one or more image and the stored corresponding image may be quantified as a proportion or percentage difference (or other normalised value) in a signal value (for instance light intensity, or RGB value) at a specific pixel, group of pixels, or region of an image. It will be understood that one or more images may represent two or more regions or specific groups of pixels in the same image. The proportion or percentage values (or other normalised value) for each one or more parameter and each one or more image may then be added in a weighted sum, and or weighted function, with the total of the weighted sum or output of the weighted function compared to a predetermined threshold in order to determine whether an anomaly is detected. For instance, an anomaly maybe detected if the total of the weighted sum or output of the weighted function exceeds the predetermined threshold. It will be understood that the weighted sum (or weighted function) is one in which each component of the sum or function is given a predefined weight (or factor).

As such, according to this example, determining if an anomaly is detected inside the enclosure by comparing at the maintenance management server the measured value of each one or more parameter to at least one stored value of a corresponding parameter and/or comparing each one or more image to at least one stored corresponding image, may comprise:
comparing the measured value of each one or more parameter and/or each one or more image to at least one stored value of a corresponding parameter or stored image; and
determining a magnitude of the proportional change between a one of the measured value of the one or more parameter and a stored value of the corresponding parameter and/or determining a magnitude of the proportional change between a numerical value characterising aspects of a one of the one or more image and the stored corresponding image;
determining a weighted sum of the proportional change in each of the one or more parameter and/or each of the one or more image;
determining that an anomaly is detected if the total of the weighted sum exceeds a predefined threshold associated with said parameter.

The weighted sum may apply a corresponding factor or weight to the proportional change in each of the one or more parameter and each of the one or more image, wherein each factor or weight may be selected according to the reliability or importance of the corresponding parameter or image to indicate an anomaly.

Issuing an alert may comprise sending a maintenance request to a user. Additionally or alternatively, issuing an alert may comprise: identifying by the maintenance management server a corrective action by comparison of a type of anomaly detected with a database of types of anomaly and predetermined corrective action; and sending a report to a user comprising type of anomaly and the identified corrective action.

Measurement of the value of the one or more parameter and acquisition of the one or more image at the enclosure may be triggered by detection of movement by a sensor and/or by at least one of the image acquisition devices and/or by detection of an event at an image change detector. For example, as the enclosures are typically closed or locked cabinets, detection of movement may be the result of incursion by an animal or even unauthorised access by a person. Therefore, it is useful to undertake the method to determine if a fault is detected in the event of such movement being identified. An image change detector is an event-based detector in which pixels are read out only when they register a significant change in signal intensity, thereby avoiding redundant data output. Event-based detectors promise higher performance at lower cost than frame-based detectors.

The value of the one or more parameter may be measured and the one or more image may be acquired after elapse of a predefined time interval since a previous measurement or image acquisition. Instead of or in addition to the method being performed on the detection of movement or an event, the method may also be repeated periodically.

Each one or more parameter characterising an environment inside the enclosure may be one from a group consisting of: humidity inside the enclosure, temperature inside the enclosure, a difference between the humidity inside and outside the enclosure, a difference between the temperature inside and outside the enclosure, concentration of particulates, concentration of carbon dioxide, detection of salt, noise, detection of carbon, light level. Any given parameter may be a measure associated with a specific location inside the enclosure (for example, the temperature at the body of a specific equipment inside the enclosure).

The at least one stored value of the corresponding parameter or the at least one stored corresponding image may be retrieved by the maintenance management server from a database of stored values of the parameter and stored images associated with the enclosure. As such, the database may act as a record of the measured parameters and acquired images for each enclosure. The measured parameters or images could be retrieved from the database by a user via a user portal in order to observe trends or calculate metrics for the enclosure.

The method may further comprise storing, by the maintenance management server in the database of stored values of the parameters and stored images, the measured value of the one or more parameter and the one or more image received at the maintenance management server from the enclosure controller. In other words, each measured value of a parameter or acquired image can be stored for use in a comparison in a future repetition of the method. The data may be used to calculate typical or running average values of the parameters, for instance.

The method may further comprise generating, by the maintenance management server, a digital twin of the enclosure from the stored values of the one or more parameter and/or the stored images in the database, the digital twin being a digital model of the enclosure. The method may further comprise accessing the digital twin via a user portal, for monitoring the enclosure. A digital twin is a direct replicate of a particular enclosure based on images and measured parameters obtained or detected within the enclosure. It may leverage existing digital twin models of respective elements or equipment together with an understanding of their layout deployment configuration in the enclosure in order to construct a full digital twin of the equipment within the enclosure.

The enclosure may be for housing a base station in a communication system, for instance a mobile base station in a mobile telecommunications network. The enclosure could be used for any other utility infrastructure that requires a distribution of equipment across a number of geographical locations. The enclosure could be used for housing utility equipment as far ranging as telecommunications switches or power generators.

The maintenance management server may be in communication with a plurality of different enclosure controllers, each located at a different enclosure of a plurality of enclosures. In this way, the method may be used for centralised monitoring of a plurality of enclosures. For example, the plurality of enclosures may each house a mobile base station of a telecommunications network.

The maintenance management server may be cloud based. The management server may be remote from the enclosure, and the enclosure controller may be in communication with the maintenance management server via a wireless network.

In a second aspect, there is a system for monitoring an enclosure for housing utilities infrastructure, comprising:
one or more sensor located at the enclosure;
one or more image acquisition device located at the enclosure;
an enclosure controller, in communication with the one or more sensor and the one or more image acquisition device; and
a maintenance management server in communication with the enclosure controller; wherein the enclosure controller is configured to:
   receive a measured value of one or more parameter characterising an environment inside the enclosure, each value measured by the respective one or more sensor located at the enclosure;
   receive one or more image depicting at least a region of the interior of the enclosure, each image acquired at the respective one or more image acquisition device located at the enclosure;
   sending to the maintenance management server the measured value of the one or more parameter and the one or more image; and
wherein the maintenance management server is configured to:
   determine if an anomaly is detected inside the enclosure by comparing the measured value of each one or more parameter to a stored value of the corresponding parameter and/or comparing each one or more image to at least one stored corresponding image, the at least one stored value of a corresponding parameter and the at least one stored corresponding image associated with the enclosure;
   wherein, if an anomaly is detected, then issue an alert.

Any of the characteristics or advantages discussed herein with respect to a feature of the method may apply to a like feature of the system.

The one or more sensors may be located inside the enclosure and/or the one or more image acquisition devices may be located inside the enclosure.

The maintenance management server being configured to determine if an anomaly is detected inside the enclosure by comparing at the maintenance management server the measured value of each one or more parameter to at least one stored value of a corresponding parameter and/or comparing each one or more image to at least one stored corresponding image, may comprise the maintenance management server being configured to: compare the measured value of each one or more parameter and/or each one or more image to at least one stored value of a corresponding parameter or stored image; and determine that an anomaly is detected if there is a difference between at least one of the measured value of the one or more parameter and the stored value of the corresponding parameter or between the one or more image and the stored corresponding image.

The maintenance management server being configured to determine that an anomaly is detected if there is a difference between at least one of the measured value of the one or more parameter and the stored value of the corresponding parameter may comprise the maintenance management server being configured to: determine a magnitude of the difference between a one of the measured value of the one or more parameter and a stored value of the corresponding parameter; determine that an anomaly is detected if the magnitude of the difference exceeds a predefined threshold associated with said parameter.

The maintenance management server being configured to determine that an anomaly is detected if there is a difference between at least one of the one or more image and the stored corresponding image may comprise the maintenance management server being configured to: determine any change between a one of the one or more image and the stored corresponding image using automated image comparison techniques; and determine that an anomaly is detected if a change is determined.

The maintenance management server being configured to determine any change between the one of the one or more image and the stored corresponding image using automated image comparison techniques may comprise the maintenance management server being configured to compare predefined areas or predefined features of each image.

The maintenance management server being configured to determine that an anomaly is detected if there is a difference between at least one of the measured value of the one or more parameter and the stored value of the corresponding parameter or between the one or more image and the stored corresponding image, may comprise the maintenance management server being configured to: determine that an anomaly is detected if there is a difference between at least two of the measured value of the one or more parameter and the stored value of the corresponding parameter and/or the one or more image and the stored corresponding image.

The maintenance management server being configured to issue an alert may comprise the maintenance management server being configured to send a maintenance request to a user.

The maintenance management server being configured to issue an alert may comprise the maintenance management server being configured to: identify by the maintenance management server a corrective action by comparison of a type of anomaly detected with a database of types of anomaly and predetermined corrective action; and send a report to a user comprising type of anomaly and the identified corrective action.

Measurement of the value of the one or more parameter and acquisition of the one or more image at the enclosure may be triggered by detection of movement by a sensor and/or by at least one of the image acquisition devices and/or by detection of an event at an image change detector.

The value of the one or more parameter may be measured and the one or more image may be acquired after elapse of a predefined time interval since a previous measurement or image acquisition.

Each one or more parameter characterising an environment inside the enclosure may be one from a group consisting of: humidity inside the enclosure, temperature inside the enclosure, a difference between the humidity inside and outside the enclosure, a difference between the temperature inside and outside the enclosure, concentration of particulates, concentration of carbon dioxide, detection of salt, noise, detection of carbon.

The at least one stored value of the corresponding parameter or the at least one stored corresponding image may be retrieved by the maintenance management server from a database of stored values of the parameter and stored images associated with the enclosure.

The maintenance management server may further be configured to store, in the database of stored values of the parameters and stored images, the measured value of the one or more parameter and the one or more image received at the maintenance management server from the enclosure controller.

The maintenance management server may be further configured to generate a digital twin of the enclosure from the stored values of the one or more parameter and/or the stored images in the database, the digital twin being a digital model of the enclosure.

Certain implementations are also described below in the form of numbered clauses:
1. A method for monitoring an enclosure for housing utility infrastructure, the enclosure having an enclosure controller in communication with a maintenance management server, the method comprising:
   receiving at the enclosure controller a measured value of one or more parameter characterising an environment inside the enclosure, each value measured by a respective one or more sensors located at the enclosure;
   receiving at the enclosure controller one or more image depicting at least a region of the interior of the enclosure, each image acquired at a respective one or more image acquisition devices located at the enclosure;
   sending by the enclosure controller to the maintenance management server the measured value of the one or more parameter and the one or more image;
   determining if an anomaly is detected inside the enclosure by comparing at the maintenance management server the measured value of each one or more parameter to at least one stored value of the corresponding parameter and/or comparing each one or more image to at least one stored corresponding image, the at least one stored value of a corresponding parameter and the at least one stored corresponding image associated with the enclosure;
   wherein, if an anomaly is detected, then issuing an alert by the maintenance management server.
2. The method of clause 1, wherein the one or more sensors are located inside the enclosure and/or the one or more image acquisition devices are located inside the enclosure.
3. The method of clause 1 or clause 2, wherein determining if an anomaly is detected inside the enclosure by comparing at the maintenance management server the measured value of each one or more parameter to at least one stored value of a corresponding parameter and/or comparing each one or more image to at least one stored corresponding image, comprises:
   comparing the measured value of each one or more parameter and/or each one or more image to at least one stored value of a corresponding parameter or stored image; and
   determining that an anomaly is detected if there is a difference between at least one of the measured value of the one or more parameter and the stored value of the corresponding parameter or between the one or more image and the stored corresponding image.
4. The method of clause 3, wherein determining that an anomaly is detected if there is a difference between at least one of the measured value of the one or more parameter and the stored value of the corresponding parameter comprises:
   determining a magnitude of the difference between a one of the measured value of the one or more parameter and a stored value of the corresponding parameter;
   determining that an anomaly is detected if the magnitude of the difference exceeds a predefined threshold associated with said parameter.
5. The method of clause 3 or clause 4, wherein determining that an anomaly is detected if there is a difference between at least one of the one or more image and the stored corresponding image comprises:
   determining any change between a one of the one or more image and the stored corresponding image using automated image comparison techniques;
   determining that an anomaly is detected if a change is determined.
6. The method of clause 5, wherein determining any change between the one of the one or more image and the stored corresponding image using automated image comparison techniques comprises comparing predefined areas or predefined features of each image.
7. The method of any one of clauses 3 to 6, wherein determining that an anomaly is detected if there is a difference between at least one of the measured value of the one or more parameter and the stored value of the corresponding parameter or between the one or more image and the stored corresponding image, comprises:
   determining that an anomaly is detected if there is a difference between at least two of the measured value of the one or more parameter and the stored value of the corresponding parameter and/or the one or more image and the stored corresponding image.
8. The method of any preceding clause, wherein issuing an alert comprises sending a maintenance request to a user.
9. The method of any preceding clause, wherein issuing an alert comprises:
   identifying by the maintenance management server a corrective action by comparison of a type of anomaly detected with a database of types of anomaly and predetermined corrective action; and
   sending a report to a user comprising type of anomaly and the identified corrective action.
10. The method of any preceding clause, wherein measurement of the value of the one or more parameter and acquisition of the one or more image at the enclosure is triggered by detection of movement by a sensor and/or by at least one of the image acquisition devices and/or by detection of an event at an image change detector.
11. The method of any preceding clause, wherein the value of the one or more parameter is measured and the one or more image is acquired after elapse of a predefined time interval since a previous measurement or image acquisition.
12. The method of any preceding clause, wherein each one or more parameter characterising an environment inside the enclosure is one from a group consisting of: humidity inside the enclosure, temperature inside the enclosure, a difference between the humidity inside and outside the enclosure, a difference between the temperature inside and outside the enclosure, concentration of particulates, concentration of carbon dioxide, detection of salt, noise, detection of carbon.
13. The method of any preceding clause, wherein the at least one stored value of the corresponding parameter or the at least one stored corresponding image is retrieved by the maintenance management server from a database of stored values of the parameter and stored images associated with the enclosure.
14. The method of clause 13, further comprising storing, by the maintenance management server in the database of stored values of the parameters and stored images, the measured value of the one or more parameter and the one or more image received at the maintenance management server from the enclosure controller.
15. The method of clause 13 or clause 14, further comprising generating, by the maintenance management server, a digital twin of the enclosure from the stored values of the one or more parameter and/or the stored images in the database, the digital twin being a digital model of the enclosure.
16. The method of any preceding clause, wherein the enclosure is for housing a base station in a communication system.
17. The method of any preceding clause, wherein the maintenance management server is cloud based.
18. The method of any preceding clause, wherein the management server is remote from the enclosure, and the enclosure controller is in communication with the maintenance management server via a wireless network.
19. A system for monitoring an enclosure for housing utilities infrastructure, comprising:
   one or more sensor located at the enclosure;
   one or more image acquisition device located at the enclosure;
   an enclosure controller, in communication with the one or more sensor and the one or more image acquisition device; and
   a maintenance management server in communication with the enclosure controller;
   wherein the enclosure controller is configured to:
      receive a measured value of one or more parameter characterising an environment inside the enclosure, each value measured by the respective one or more sensor located at the enclosure;
      receive one or more image depicting at least a region of the interior of the enclosure, each image acquired at the respective one or more image acquisition device located at the enclosure;
      sending to the maintenance management server the measured value of the one or more parameter and the one or more image; and
   wherein the maintenance management server is configured to:
      determine if an anomaly is detected inside the enclosure by comparing the measured value of each one or more parameter to a stored value of the corresponding parameter and/or comparing each one or more image to at least one stored corresponding image, the at least one stored value of a corresponding parameter and the at least one stored corresponding image associated with the enclosure;
      wherein, if an anomaly is detected, then issue an alert.

### Brief description of the figures

The disclosure may be put into practice in various ways, some of which will now be described by way of example only and with reference to the accompanying drawings in which:
FIGURE 1 is an image of the build-up of dirt and dust at an air inlet of a piece of equipment previously housed in an enclosure;
FIGURE 2 is a schematic diagram of the disclosed system for monitoring an enclosure for housing utilities infrastructure;
FIGURE 3 is a flow diagram of the method for monitoring an enclosure for housing utilities infrastructure;
FIGURE 4 is an image of an example location of an enclosure controller within an enclosure.
It will be understood that like features are labelled using like reference numerals. The figures are not to scale.

### Detailed description of specific examples

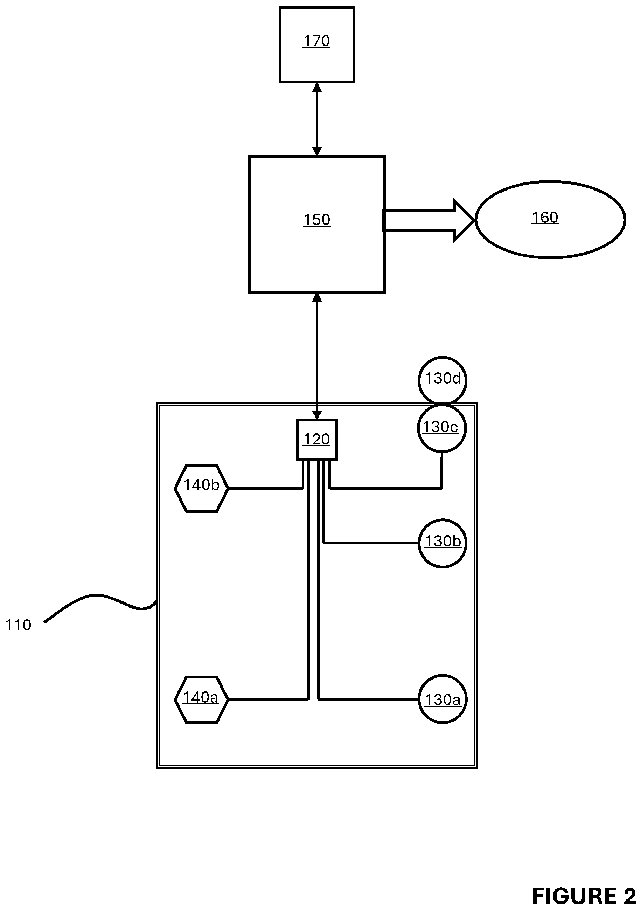

Referring to FIGURE 2, there is shown a system for monitoring an enclosure for housing utility infrastructure. The system comprises an enclosure 110, which may house various equipment (not shown) such as a mobile base station for use in a telecommunications network. The enclosure may house any other equipment forming part of a utility infrastructure, for instance network switches or a power generator.

An enclosure controller 120, four sensors 130a, 130b, 130c, 130d and two image acquisition devices 140a, 140b are arranged at the enclosure 110. It will be understood that the number of sensors and image acquisition devices shown in FIGURE 2 is exemplary only, and a greater or lesser number of sensors and image acquisition devices could be used.

The sensors 130a, 130b, 130c, 130d are for measurement of a parameter characterising an environment inside the enclosure. Each sensor may be configured to measure a different parameter, or a value from which a relevant parameter could be calculated. Some of the sensors 130a, 130b, 130c, 130d in FIGURE 2 are housed within the enclosure, and directly measure a parameter that characterises the interior environment of the enclosure. For instance, a first sensor 130a may measure the humidity inside the enclosure, and a second sensor 130b may measure the concentration of particulates inside the enclosure. Other sensors (such as the fourth sensor 130d in FIGURE 2) is arranged outside the enclosure. In the example of FIGURE 2, the third sensor 130c and fourth sensor 130d are arranged to measure a parameter representing a difference in an environmental characteristic inside the enclosure compared to the same characteristic outside the enclosure. For instance, the third and fourth sensor 130c, 130d of FIGURE 2 may measure the difference in the air temperature inside the enclosure compared to the air temperature outside the enclosure.

The image acquisition devices 140a, 140b are arranged at or within the enclosure, in order to capture images of areas or regions inside the enclosure. The image acquisition devices 140a, 140b may be arranged to obtain images of the whole interior, or only specific parts (for example, an indicator at a particular piece of equipment, or an air inlet at a particular piece of equipment).

The enclosure controller 120 is further arranged in communication with a maintenance management server 150. The maintenance management server 150 can be housed within the enclosure, or (as in FIGURE 2) the maintenance management server 150 can be arranged remote to the enclosure 110 and in communication with the enclosure controller 120 through a wireless network. The maintenance management server 150 is further in communication with a user portal or user interface 160. The maintenance management server 150 may deliver information about the enclosure 110 to a user through the user interface 160.

Finally, the system comprises a database 170, which stores information that can be retrieved by the maintenance management server 150. The maintenance management server 150 may also store data within the database 170.

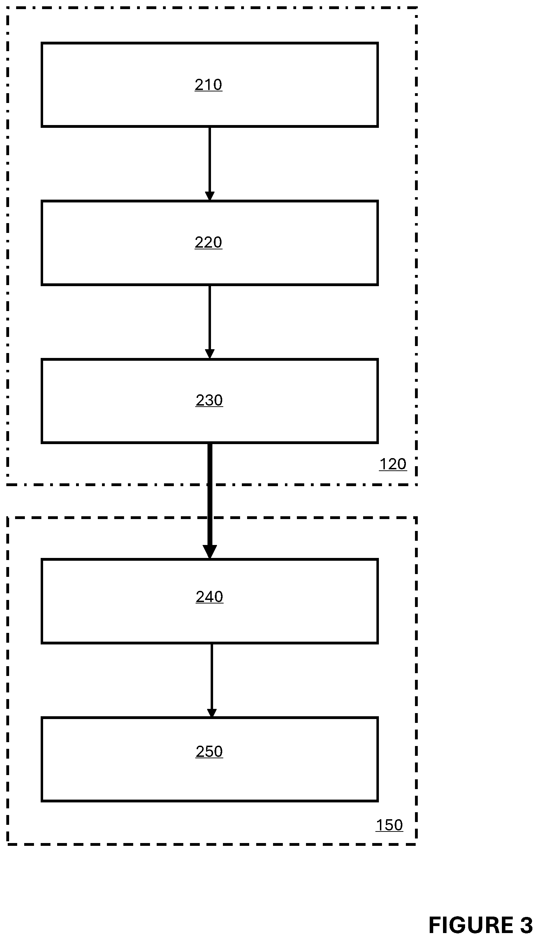

FIGURE 3 shows the steps of a method for monitoring an enclosure 110 for housing utility infrastructure. The method takes place at the system of FIGURE 2. In general, the enclosure controller 120 receives measurements and images from the sensors 130a, 130b, 130c, 130d and image acquisition devices 140a, 140b, and sends these to the maintenance management server 150. The maintenance management server 150 analyses the received images and measurements, in order to detect an anomaly or fault. The maintenance management server 150 may also take further action in the event of identification of an anomaly. It will be understood that the enclosure 110 and the maintenance management server 150 may be part of the same element and/or local to each other, or may be entirely separate elements that are only in communication via a network (wired or wireless). In some cases, the maintenance management server 150 is cloud based.

In a first step 210, the enclosure controller 120 receives a measurement of one or more parameter characterising an environment inside the enclosure 110. Each measurement is acquired from one or more of the sensors 130a, 130b, 130c, 130d located at the enclosure 110. The parameter may be any characteristic of the environment of the enclosure 110. For instance, parameters may include the humidity inside the enclosure, the temperature inside the enclosure, a difference between the humidity inside and outside the enclosure, a difference between the temperature inside and outside the enclosure, a concentration of particulates, a concentration of carbon dioxide, a detection of salt, noise level, light levels inside the enclosures or a detection of carbon. In some cases, the parameter may be a characteristic of a particular location or piece of equipment inside the enclosure. For instance, the parameter may be a server inlet temperature or a server outlet temperature.

In a second step 220, the enclosure controller 120 receives one or more images acquired at a respective one or more image acquisition devices 140a, 140b, 140c located at the enclosure. Each image depicts at least a region of the interior of the enclosure 110. The image may represent a large area of the interior of the enclosure, or may focus on a particular portion or aspect of the enclosure. For instance, the image acquisition devices 140a, 140b may be directed or aligned to obtain an image of aspects at the interior to the enclosure such as LED indicators, specific wires, air inlets or outlets at an equipment, or a seal to a door of the enclosure.

In a third step 230, the enclosure controller 120 sends to the maintenance management server 150 each measured value of the one or parameter and/or the one or more image.

In a fourth step 240, the maintenance management server 150 detects an anomaly inside the enclosure 110. The maintenance management server 150 detects an anomaly by comparing the measured value of each one or more parameter to at least one stored value of a corresponding parameter and/or by comparing each one or more image to at least one stored corresponding image. In some cases, only a comparison of the measured value of one or more parameter will occur, or only a comparison of one or more image. However, in other cases, a comparison of more than one parameter, more than one image or a combination of both will take place. Comparison of more parameters and/or images will often yield a more reliable detection of an anomaly (with fewer false positives), as each parameter or image may allow detection of different type of anomaly or fault or different consequence of a fault.

It will be understood that the detection of an anomaly may be based on a weighted cumulation of different parameters and/or images. The weightings may be based on the importance of certain aspects to the function of the enclosure and the level of risk indicated by each parameter or image. The weightings may differ for different enclosures (at different geographical locations) and could change dynamically for different seasons or times of day. For instance, a parameter indicating the detection of carbon may be always heavily weighted, as this could indicate burning in the interior of the enclosure which could lead to a safety risk and catastrophic failure. However, the presence of a higher temperature at midday in midsummer may be less heavily weighted, as this may not indicate an immediate fault (although could be an indication of a possible future problem). It will be understood that in a combination of various parameters and images, some could be weighted as zero and therefore excluded from that particular combination.

The detection of an anomaly may involve comparing the measured value of each one or more parameter to a stored value of a corresponding parameter and determining if there is a difference. The detection of the anomaly may also involve comparing each acquired image with a corresponding stored image, and identifying if the there is a difference between the images. If a difference is determined in at least one of a parameter or an image, then an anomaly is detected. In some cases, a difference is only determined where the magnitude of the difference (for instance, between the value of a measured parameter and a stored parameter) exceeds a predefined threshold.

In some cases, the anomaly is determined to be detected if a difference is identified in both a parameter and an image, or in two or more of the group of parameters and image compared. The detection of an anomaly may be more reliable if a difference is required in more than two of the parameters or images in order to determine that an anomaly is detected.

In a fifth step 250, the maintenance management server 150 issues an alert if an anomaly has been detected. In particular, the maintenance management server 150 may initiate an alarm at a user interface 160, or send a message to a user interface 160 indicating that an anomaly has been detected. In one example, issuing an alert causes the maintenance management server 150 to send a maintenance request to a user (for instance, by sending an email message or message to a maintenance log).

In a particular example, the maintenance management server 150 may identify a corrective action for the anomaly. This may involve comparing the type or category of anomaly with a database of types of anomalies and corresponding predetermined corrective action (which may be database 170 in FIGURE 2). The maintenance management server 150 may then send a report to a user reporting the type of anomaly and identified corrective action. Alternatively or additionally, the maintenance management server 150 can send an automated instruction to the enclosure controller to take an action at the enclosure. For instance, the anomaly detected may be that the temperature in the interior of the enclosure 110 that is deemed too high. The maintenance management server 150, after identifying that the temperature is too high, may consult a database and determine a corrective action for this anomaly. Said corrective action may be to initiate shut down of a piece of equipment at the enclosure. The maintenance management server 150 may issue a report to the user and also send an instruction to the enclosure controller to shut down the piece of equipment.

Various methods can be employed for determining a difference between the measured value of a parameter and the stored value of a parameter, in order to detect an anomaly according to the fourth step above. In one example, as noted above, the magnitude of a difference can be calculated between a measured value of a parameter and a stored value of the corresponding parameter. The difference can then be compared with a predefined threshold associated with that parameter. If the difference exceeds the threshold, then the anomaly is detected. The predefined threshold for each parameter can be stored in a database, such as the database 170 in communication with the management maintenance server 150.

In an alternative, the difference between the measured value and the stored value of the parameter could be calculated as a percentage of the stored value (i.e. a percentage change). The anomaly is then detected if the percentage change exceeds a certain predefined value (for instance, exceeds ±5% of the stored value). In this case, the percentage change could be considered to represent the predefined threshold. Once again, the percentage change (as the predefined threshold) may be stored at a database 170.

Various methods may also be employed for determining a difference between an acquired image and a stored, corresponding image. In one example, the maintenance management server 150 identifies a change after comparison of frames of an image depicting nominally the same region or aspect of the interior of the enclosure 110 (for instance, the same area of the enclosure, or a particular aspect of an equipment such as the air outlet of a given equipment). In some cases, only predefined areas of an acquired image may be compared with a stored image (for instance a certain group of pixels within each frame). The comparison may compare aspects of the image such as signal intensity or RGB levels received at corresponding pixels. Machine learning techniques could be used to identify differences between the acquired and stored images, after appropriate training using a suitable data set.

The method described could be instigated or triggered through various mechanisms. In some examples, the method is repeated periodically. For example, after elapse of a predefined time interval the method is performed (i.e. a measurement of each parameter is made and/or acquisition of an image is triggered, and the other steps follow). The time interval may be 1 hour, or 24 hours, for instance. The time interval may be chosen based on the expected time span over which most common anomalies occur at a particular enclosure or housed set of equipment. For instance, where equipment in an enclosure 110 often fails due to a build-up of dirt, the time period may be every 7 days, because the build-up of dirt will be gradual. However, if a common fault is the overheating of equipment in the enclosure 110, then the time interval may be every hour, to take account of the shorter time scale for environmental temperature changes. The time interval may be adjusted according to the time of day (i.e. during the hottest hours of the day, the time interval may be shorter than at night), or according to season (i.e. In the summer, the time interval may be shorter than in the winter).

In a further example, the method could be triggered by detection of motion inside the enclosure 110 (for instance, by one of the image acquisition devices). This could be used where the most common failures are due to the incursion of an animal or rodent into the enclosure (for instance, a rodent which may chew electrical wires). An image change detector (not shown in FIGURE 2) could also be used to trigger the method. An image change detector is an event-based detector in which pixels are read out only when they register a significant change in signal intensity, thereby avoiding redundant data output. This could subsequently trigger measurement of a parameter. Event-based detectors promise higher performance at lower cost than frame-based detectors. It will be understood that after the method is initiated by detection of motion or via an image change detector, this could instigate periodic repetition of the method thereafter for a predetermined time period. For instance, the method initially could be triggered by detection of motion, but the method could afterwards be repeated every 30 minutes, for the subsequent 24-hour period. In this way, the event-based and the periodic triggering of the method could be combined.

In a particular example, after determining if an anomaly is detected, the maintenance management server 150 may store the measured value of each parameter and/or the acquired image at a database 170. In this way, the values and images are stored for use in future comparisons when determining if an anomaly is detected at the enclosure 110. The values and images may be stored in the database 170 associated with the particular enclosure 110 (for example, via use of an identifier of the enclosure 110). The values and/or images may be stored with a time and date, to allow the most recent value and/or image, or a value and/or image at a comparable time of day or season (for instance), to be used in a future determination or detection of an anomaly. In some cases, the value of a parameter may be used to calculate an updated or running average value for the given parameter for the associated enclosure. The average can then be stored in the database 170. The stored values of the parameter and the stored images could be retrieved by a user in order to obtain metrics and historical information on the interior environment of the enclosure 110.

In some cases, the stored values of each parameter (including the measured value) and the stored images (including the acquired images) in the database 170 can be used to construct a digital twin of a given enclosure. For instance, a digital twin can be generated by the maintenance management server 150, to be accessed by a user via the user interface or a user portal. The digital twin is a virtual representation of the enclosure 110, designed to accurately represent the physical representation of the enclosure. It can be used for better, more intuitive monitoring of the enclosure by the user. For instance, using the parameter values and images stored at a database 170 for a given enclosure, the maintenance management server 150 can build a full virtual replicate of the enclosure 110 by leveraging existing digital twin models of respective elements, understanding their layout, and determining their deployment configuration in the enclosure.

It will be understood that the system described in this disclosure may form part of a maintenance management system comprising a plurality of enclosures, for instance each housing a mobile communications base station and located at a different geographical location. Each enclosure of the plurality of enclosures may comprise an enclosure controller, and the enclosure controller may be arranged in communication with a central maintenance management controller. The method described herein may take place with respect to each enclosure separately, but the maintenance management server may act in communication with a user interface to provide a central portal for sending and receiving alerts from the various enclosures. It will be understood that such a maintenance management server could also be used to receive instructions from the user interface to pass to a given enclosure controller in the maintenance management system (for example, an instruction from a user to shut down a specified piece of equipment at a particular enclosure).

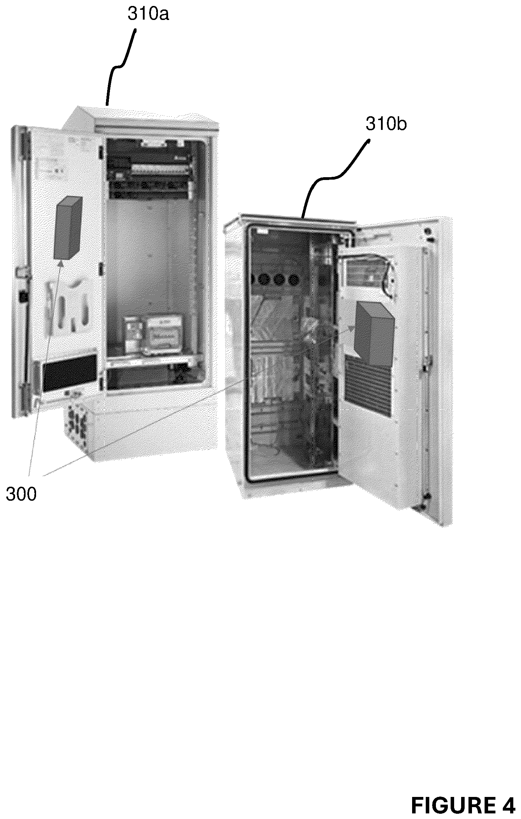

FIGURE 4 shows an example of the location of an enclosure controller 300 at an interior wall of example enclosures 310a, 310b, for instance for a type suitable for housing a base station. It will be understood that various other locations or positions are equally possible. Where the maintenance management server is also housed within the enclosure, the maintenance management server may, as an example, be located in the same housing or box as the enclosure controller.

Although examples according to the disclosure have been described with reference to specific illustrative examples, other approaches according to the disclosure may be used. Certain features may be omitted or substituted, for example as indicated herein. Each feature disclosed in this specification, unless stated otherwise, may be replaced by alternative features serving the same, equivalent or similar purpose. Thus, unless stated otherwise, each feature disclosed is one example only of a generic series of equivalent or similar features.

In this detailed description of the various examples and/or embodiments, for the purposes of explanation, numerous specific details are set forth to provide a thorough understanding of the examples and/or embodiments disclosed. One skilled in the art will appreciate, however, that these various examples and/or embodiments may be practiced with or without these specific details. Furthermore, one skilled in the art can readily appreciate that the specific sequences in which methods are presented and performed are illustrative and it is contemplated that the sequences can be varied and still remain within the scope of the various examples and/or embodiments disclosed herein.

As used herein, including in the claims, unless the context indicates otherwise, singular forms of terms are to be construed as including the plural form and vice versa. For instance, unless the context indicates otherwise, a singular reference herein including in the claims, such as "a" or "an" means "one or more". Throughout the description and claims of this disclosure, the words "comprise", "including", "having" and "contain" and variations of the words, for example "comprising" and "comprises" or similar, mean "including but not limited to", and are not intended to (and do not) exclude other components. Also, the use of "or" is inclusive, such that the phrase "A or B" is true when "A" is true, "B" is true, or both "A" and "B" are true.

The use of any and all examples, or exemplary language ("for instance", "such as", "for example" and like language) provided herein, is intended merely to better illustrate the disclosure and does not indicate a limitation on the scope of the disclosure unless otherwise claimed. No language in the specification should be construed as indicating any non-claimed element as essential to the practice of the disclosure.

The terms "first" and "second" may be reversed without changing the scope of the disclosure. That is, the terms are relative such that an element termed a "first" element or position may instead be termed a "second" element or position and an element termed a "second" element or position may instead be considered a "first" element or position.

Any steps described in this specification may be performed in any order or simultaneously unless stated or the context requires otherwise. Moreover, where a step is described as being performed after another step, this does not preclude intervening steps being performed.

It is also to be understood that, for any given component, example or embodiment described herein, any of the possible candidates or alternatives listed for that component may generally be used individually or in combination with one another, unless implicitly or explicitly understood or stated otherwise. It will be understood that any list of such candidates or alternatives is merely illustrative and not limiting, unless implicitly or explicitly understood or stated otherwise.

## Claims

1. A method for monitoring an enclosure for housing utility infrastructure, the enclosure having an enclosure controller in communication with a maintenance management server, the method comprising:
receiving at the enclosure controller a measured value of one or more parameter characterising an environment inside the enclosure, each value measured by a respective one or more sensors located at the enclosure;
receiving at the enclosure controller one or more image depicting at least a region of the interior of the enclosure, each image acquired at a respective one or more image acquisition devices located at the enclosure;
sending by the enclosure controller to the maintenance management server the measured value of the one or more parameter and the one or more image;
determining if an anomaly is detected inside the enclosure by comparing at the maintenance management server the measured value of each one or more parameter to at least one stored value of the corresponding parameter and/or comparing each one or more image to at least one stored corresponding image, the at least one stored value of a corresponding parameter and the at least one stored corresponding image associated with the enclosure;
wherein, if an anomaly is detected, then issuing an alert by the maintenance management server.

2. The method of claim 1, wherein the one or more sensors are located inside the enclosure and/or the one or more image acquisition devices are located inside the enclosure.

3. The method of claim 1 or claim 2, wherein determining if an anomaly is detected inside the enclosure by comparing at the maintenance management server the measured value of each one or more parameter to at least one stored value of a corresponding parameter and/or comparing each one or more image to at least one stored corresponding image, comprises:
comparing the measured value of each one or more parameter and/or each one or more image to at least one stored value of a corresponding parameter or stored image; and
determining that an anomaly is detected if there is a difference between at least one of the measured value of the one or more parameter and the stored value of the corresponding parameter or between the one or more image and the stored corresponding image.

4. The method of claim 3, wherein determining that an anomaly is detected if there is a difference between at least one of the measured value of the one or more parameter and the stored value of the corresponding parameter comprises:
determining a magnitude of the difference between a one of the measured value of the one or more parameter and a stored value of the corresponding parameter;
determining that an anomaly is detected if the magnitude of the difference exceeds a predefined threshold associated with said parameter.

5. The method of claim 3 or claim 4, wherein determining that an anomaly is detected if there is a difference between at least one of the one or more image and the stored corresponding image comprises:
determining any change between a one of the one or more image and the stored corresponding image using automated image comparison techniques;
determining that an anomaly is detected if a change is determined.

6. The method of claim 5, wherein determining any change between the one of the one or more image and the stored corresponding image using automated image comparison techniques comprises comparing predefined areas or predefined features of each image.

7. The method of any one of claims 3 to 6, wherein determining that an anomaly is detected if there is a difference between at least one of the measured value of the one or more parameter and the stored value of the corresponding parameter or between the one or more image and the stored corresponding image, comprises:
determining that an anomaly is detected if there is a difference between at least two of the measured value of the one or more parameter and the stored value of the corresponding parameter and/or the one or more image and the stored corresponding image.

8. The method of any preceding claim, wherein issuing an alert comprises:
identifying by the maintenance management server a corrective action by comparison of a type of anomaly detected with a database of types of anomaly and predetermined corrective action; and
sending a report to a user comprising type of anomaly and the identified corrective action.

9. The method of any preceding claim, wherein measurement of the value of the one or more parameter and acquisition of the one or more image at the enclosure is triggered by detection of movement by a sensor and/or by at least one of the image acquisition devices and/or by detection of an event at an image change detector.

10. The method of any preceding claim, wherein the value of the one or more parameter is measured and the one or more image is acquired after elapse of a predefined time interval since a previous measurement or image acquisition.

11. The method of any preceding claim, wherein each one or more parameter characterising an environment inside the enclosure is one from a group consisting of: humidity inside the enclosure, temperature inside the enclosure, a difference between the humidity inside and outside the enclosure, a difference between the temperature inside and outside the enclosure, concentration of particulates, concentration of carbon dioxide, detection of salt, noise, detection of carbon.

12. The method of any preceding claim, wherein the at least one stored value of the corresponding parameter or the at least one stored corresponding image is retrieved by the maintenance management server from a database of stored values of the parameter and stored images associated with the enclosure.

13. The method of claim 12, further comprising generating, by the maintenance management server, a digital twin of the enclosure from the stored values of the one or more parameter and/or the stored images in the database, the digital twin being a digital model of the enclosure.

14. The method of any preceding claim, wherein the maintenance management server is remote from the enclosure, and the enclosure controller is in communication with the maintenance management server via a wireless network.

15. A system for monitoring an enclosure for housing utilities infrastructure, comprising:
one or more sensor located at the enclosure;
one or more image acquisition device located at the enclosure;
an enclosure controller, in communication with the one or more sensor and the one or more image acquisition device; and
a maintenance management server in communication with the enclosure controller;
wherein the enclosure controller is configured to:
receive a measured value of one or more parameter characterising an environment inside the enclosure, each value measured by the respective one or more sensor located at the enclosure;
receive one or more image depicting at least a region of the interior of the enclosure, each image acquired at the respective one or more image acquisition device located at the enclosure;
sending to the maintenance management server the measured value of the one or more parameter and the one or more image; and
wherein the maintenance management server is configured to:
determine if an anomaly is detected inside the enclosure by comparing the measured value of each one or more parameter to a stored value of the corresponding parameter and/or comparing each one or more image to at least one stored corresponding image, the at least one stored value of a corresponding parameter and the at least one stored corresponding image associated with the enclosure;
wherein, if an anomaly is detected, then issue an alert.
